# EUROPEAN PATENT APPLICATION

(11) **EP 4 156 295 A1**
(43) Date of publication of application: **29.03.2023**
(21) Application number: 22191534.1
(22) Date of filing: 22.08.2022
(51) Int. Cl.: H01L 29/775, H01L 21/336, H01L 29/423, H01L 29/24, H01L 29/06, H01L 29/417, H01L 29/778, H01L 29/786

(54) **TRANSISTOR STRUCTURE WITH A MONOLAYER EDGE CONTACT**

(30) Priority: 24.09.2021 US 202117484970
(71) Applicant: Intel Corporation, Santa Clara, CA 95054 (US)
(72) Inventor: O'BRIEN, Kevin P., Portland, 97209 (US); DOROW, Chelsey, Portland, 97209 (US); NAYLOR, Carl, Portland, 97229 (US); AVCI, Uygar, Portland, 97225 (US); TRONIC, Tristan, Aloha, 97003 (US); PENUMATCHA, Ashish Verma, Beaverton, 97003 (US); MAXEY, Kirby, Hillsboro, 97124 (US); LEE, Sudarat, Hillsboro, 97124 (US); CLENDENNING, Scott, Portland, 97225 (US)
(74) Representative: HGF

(57) **Abstract**

Embodiments described herein may be related to apparatuses, processes, and techniques related to a transistor structure that includes a monolayer within an oxide material on a gate metal. There may be a stack of these structures. The monolayer, which may include a semiconductor material, in embodiments may include multiple monolayer sheets that are stacked on top of each other. Other embodiments may be described and/or claimed.

## Description

### FIELD

Embodiments of the present disclosure generally relate to the field of semiconductor packaging, and in particular to gates in a transistor structure.

### BACKGROUND

Continued growth in virtual machines, cloud computing, and portable devices will continue to increase the demand for high density transistors within chips and packages.

### BRIEF DESCRIPTION OF THE DRAWINGS

FIG. 1 illustrates a perspective view of a transistor structure with a monolayer edge contact, in accordance with various embodiments.
FIG. 2 illustrates a monolayer, in accordance with various embodiments.
FIG. 3 illustrates a cross section side view of a transistor structure with multiple monolayers, in accordance with various embodiments.
FIGs. 4A-4AD illustrate various manufacturing stages for a transistor structure with a monolayer edge contact, in accordance with various embodiments.
FIG. 5 illustrates an example process for manufacturing a transistor structure with a monolayer edge contact, in accordance with various embodiments.
FIG. 6 illustrates a computing device 600 in accordance with one implementation of the invention.
FIG. 7 illustrates an interposer 700 that includes one or more embodiments of the invention.

### DETAILED DESCRIPTION

Embodiments described herein may be related to apparatuses, processes, and techniques directed to a transistor structure that includes a monolayer within an oxide material on a gate metal. The monolayer may be referred to as a monolayer sheet, a two dimensional (2D) channel, transition metal dichalcogenides (TMD) materials, a nanosheet, or a nanoribbon. In embodiments, the monolayer includes a semiconductor material. In embodiments, a monolayer may include multiple monolayer sheets that are stacked on top of each other, for example, three monolayer sheets that are stacked on top of each other. In embodiments, there may be a stack of monolayer/oxidematerial/gate metal structures of arbitrary depth. In embodiments, an edge of the monolayer may couple with a surface of one or more contact metals.

In legacy implementations, a gate length may be on the order of 15 nm. In order to shrink this gate length distance, silicon thickness needs to be reduced. However, and these legacy implementations, a silicon thickness that is too thin may cause a mobility decrease and result in a defective transistor.

In embodiments, by using one or more monolayers within a gate structure, distances between layers may be reduced to 6 nm or less, which may also allow an increase in the number of monolayers within the gate structure.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

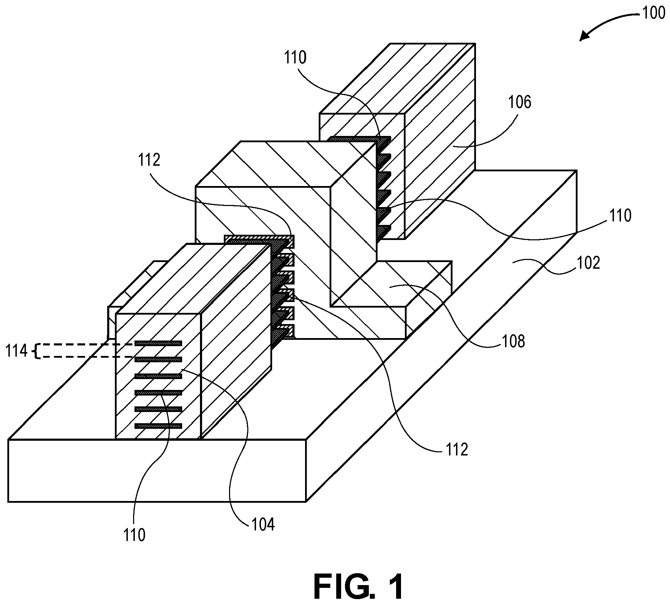

FIG. 1 illustrates a perspective view of a transistor structure with a monolayer edge contact, in accordance with various embodiments. Gate structure 100 is a perspective view that includes a substrate 102, a source 104, a drain 106, and a gate 108. In embodiments, a plurality of monolayers 110 may extend through the gate 108 and come into contact with the source 104 and the drain 106. In embodiments, a gate oxide 112 may partially and/or completely surround the monolayers 110. In embodiments, a spacing 114 between the monolayers 110 may be 8 nm plus or minus 2 nm.

In embodiments, each of the monolayers 110 may be made up of a single monolayer. In other embodiments, each of the monolayers 110 may be multiple monolayers that are stacked on top of each other. In embodiments, an edge of the monolayer may couple directly with the source 104 or the drain 106 through an edge coupling, as discussed in greater detail below.

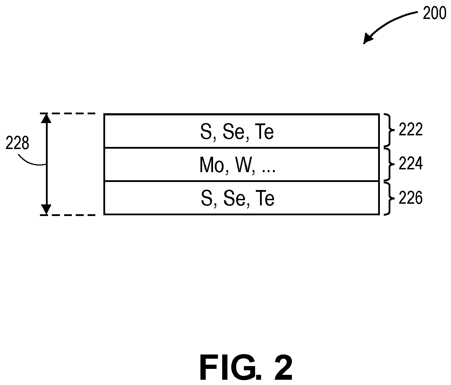

FIG. 2 illustrates a monolayer, in accordance with various embodiments. Monolayer 200 may include a first layer 222 and a third layer 226 that may include sulfur (S), selenium (Se), and/or tellurium (Te), and a second (middle) layer 224 that may include tungsten (W), and/or molybdenum (Mo). These may include examples of a TMD. The first layer 222, the second layer 224, and the third layer 226 may each include a layer of atoms that are interconnected. A height 228 of the monolayer may be on the order of 3.3 Å.

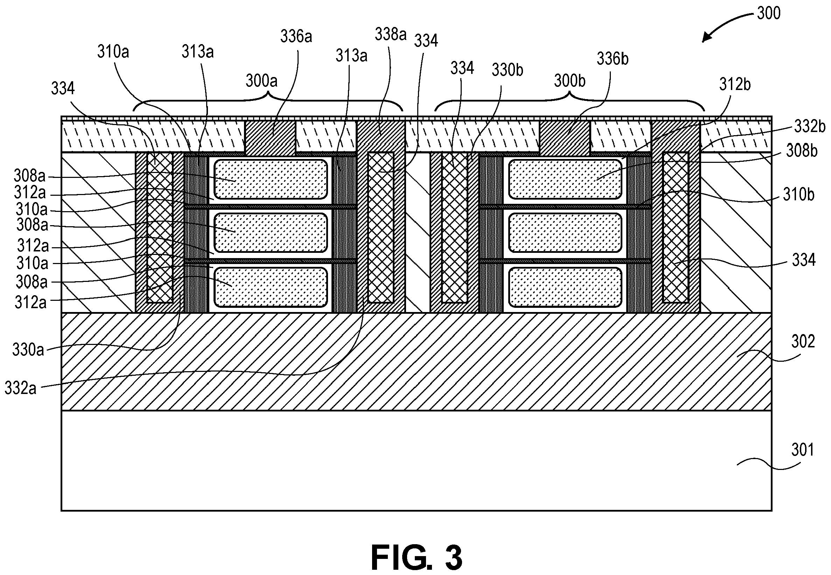

FIG. 3 illustrates a cross section side view of a transistor structure with multiple monolayers, in accordance with various embodiments. Transistor structure 300 includes a substrate 302, on which a first transistor structure 300a and a second transistor structure 300b are formed. In embodiments, there may be a layer below the substrate 302, which may be a dielectric, or may include silicon, oxygen, carbon, aluminum, and/or nitrogen. First transistor structure 300a may include a plurality of gate metals 308a that are each surrounded by a gate oxide layer 312a, with a monolayer 310a within the gate oxide layer 312a. Edges of the respective monolayers 310a couple with a first contact metal 330a and a second contact metal 332a. In embodiments, the first contact metal 330a may surround a fill metal 334, and the second contact metal 332a may also surround a fill metal 334. A first electrical contact 336a may be electrically coupled with the gate metal 308a, and a second electrical contact 338a may be electrically coupled with the second contact metal 332a. In embodiments, if the gate oxide layer 312a includes only hafnium, this will be considered an Nmos transistor.

Similarly, second transistor structure 300b may include a plurality of gate metals 308b that are each surrounded by a gate oxide layer 312b, with a monolayer 310b within the gate oxide layer 312b. Edges of the respective monolayers 310b couple with a first contact metal 330b and a second contact metal 332b. In embodiments, the first contact metal 330b may surround a fill metal 334, and the second contact metal 332b may also surround a fill metal 334. A first electrical contact 336b may be electrically coupled with the gate metal 308b, and a second electrical contact 338b may be electrically coupled with the second contact metal 332b. In embodiments, if the gate oxide layer 312b includes aluminum, this will be considered a Pmos transistor.

Note that there are only three layers of monolayers 310a, 310b shown, however there may be multiple layers. In embodiments, there may be seven or more layers. In addition, each of the monolayers 310a, 310b itself may be made of a plurality of monolayers that are stacked on top of each other. For example, there may be up to three stacked monolayers that make up one monolayer 310a, 310b. In embodiments, there may be plurality of monolayers that have a tri-layer stack or other layer stack that may include MoS₂, WS₂, or MoS₂.

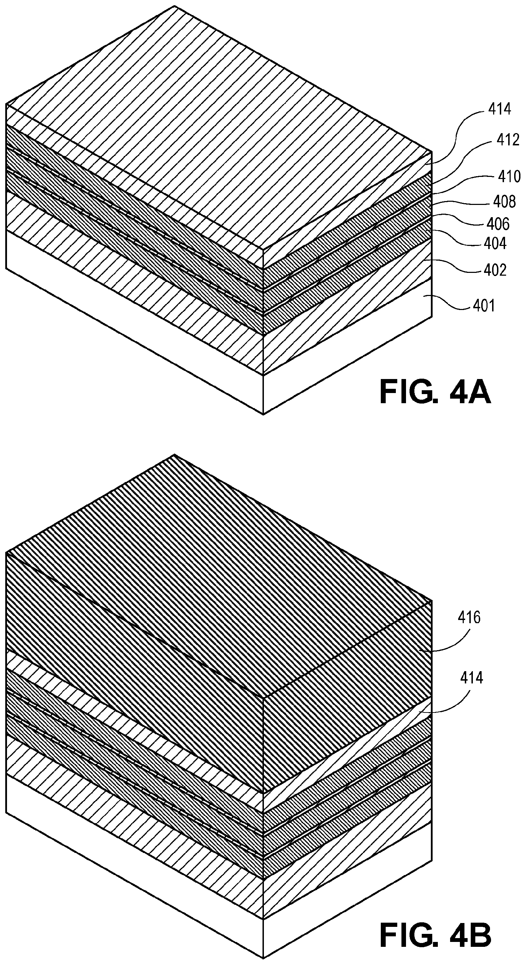

FIGs. 4A-4AD illustrate various manufacturing stages for a transistor structure with a monolayer edge contact, in accordance with various embodiments. FIG. 4A shows a stage in the manufacturing process that includes creating a substrate 401 that may include silicon, or silicon oxide, and then applying an etch-stop layer 402 onto substrate 401 that may include SiO, SiN, or SiC. A sacrificial layer 404 may then be applied, that in embodiments may be 10 to 20 nm in depth in and may include SiO₂, Al₂O₃, or MoO₃.

On top of the sacrificial layer 404, a monolayer 406 may be applied, which may also be referred to as a 2D Transition Metal Dichalcogenide (TMD), and may be similar to monolayer 310a, 310b of FIG. 3. In embodiments, monolayer 406 may include any combinations of Mo, W, Se, or Te. In embodiments, the monolayer 406 include multiple monolayers that may be applied each on top of the other.

On top of the monolayer 406, another sacrificial layer 408, which may be similar to sacrificial layer 404, may be applied, onto which another monolayer 410, which may be similar to monolayer 406, may then be applied. Another sacrificial layer 412, which may be similar to sacrificial layer 408, may then be applied onto the monolayer 410. In this embodiment, there are two stacked monolayers 406, 410, which may also be referred to as two stacked nanoribbons. In other embodiments there may be an arbitrary number of stacked monolayers, up to and including eight or more stacked monolayers. On top of sacrificial layer 412, a hard mask 414 is added, which may be a silicon carbide (SiC) hard mask.

FIG. 4B shows a stage in the manufacturing process where a photoresist 416 is applied on top of the hard mask 414.

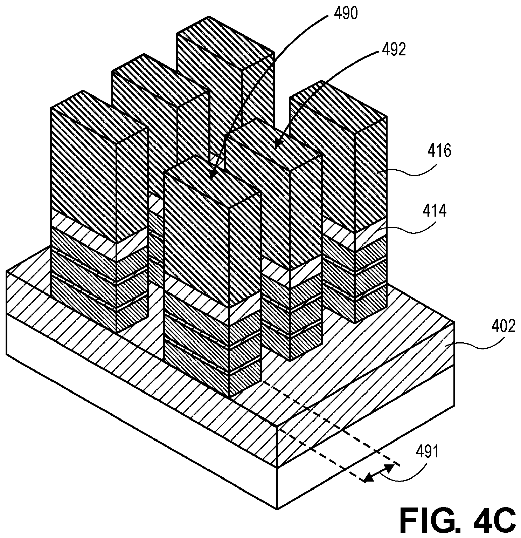

FIG. 4C shows a stage in the manufacturing process where an etch is performed down to the etch stop layer 402. The resulting cells 490, 492 will eventually become either an Nmos or Pmos. In embodiments, the width 491 of the resulting cell 490 may be between 10 nm and 100 nm, depending upon the desired function of the cell.

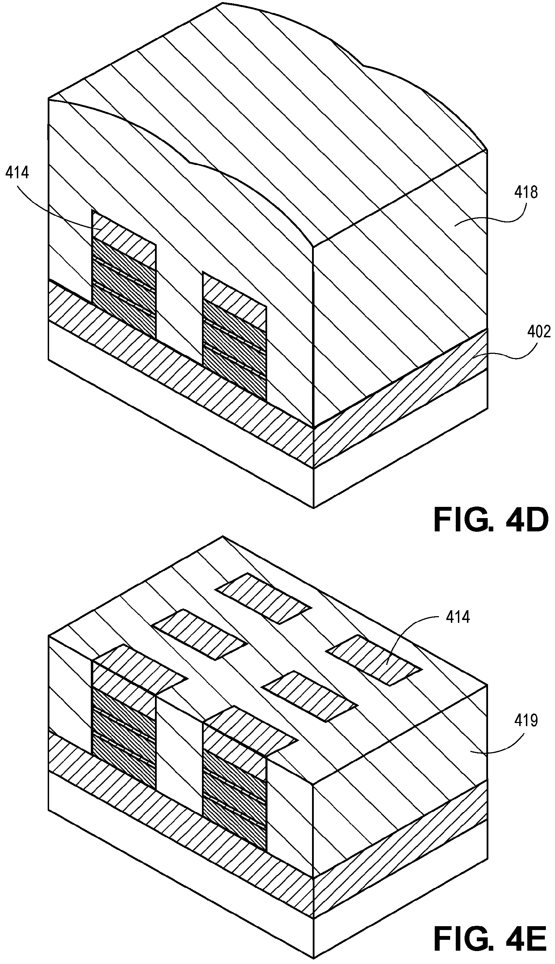

FIG. 4D shows a stage in the manufacturing process where the photoresist 416 and the hard mask 414 from FIG. 4C is removed, and dense covering 418 is applied. In embodiments, the dense covering 418 may be silicon nitride, and may be applied using chemical vapor deposition techniques.

FIG. 4E shows a stage in the manufacturing process where the dense covering 418 of FIG. 4D is etched and/or polished to the hard mask 414 to create a dense covering 419.

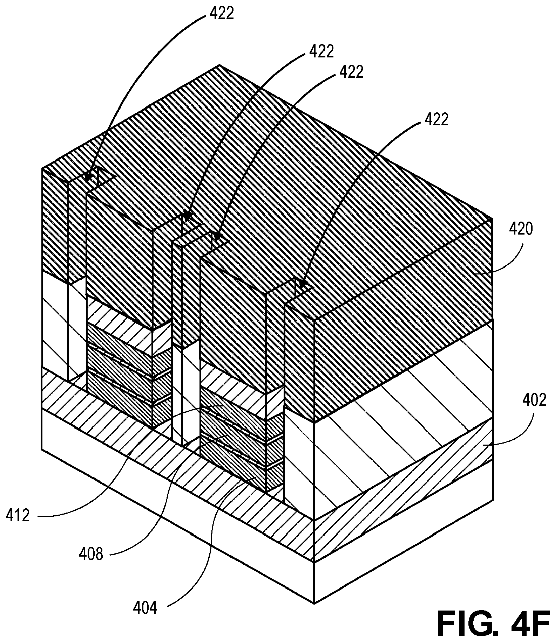

FIG. 4F shows a stage in the manufacturing process where another photoresist layer 420 is applied, and then openings 422 created within the photoresist layer 420, with subsequent etching down to the etch stop layer 402. The result of this stage is to expose the edges of the sacrificial layers 404, 408, 412.

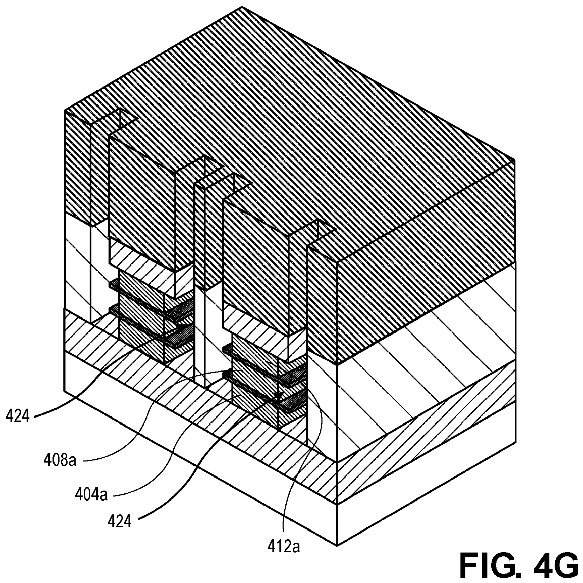

FIG. 4G shows a stage in the manufacturing process where the edges of the sacrificial layers 404, 408, 412 are etched 424 to create sacrificial layers 404a, 408a, 412a.

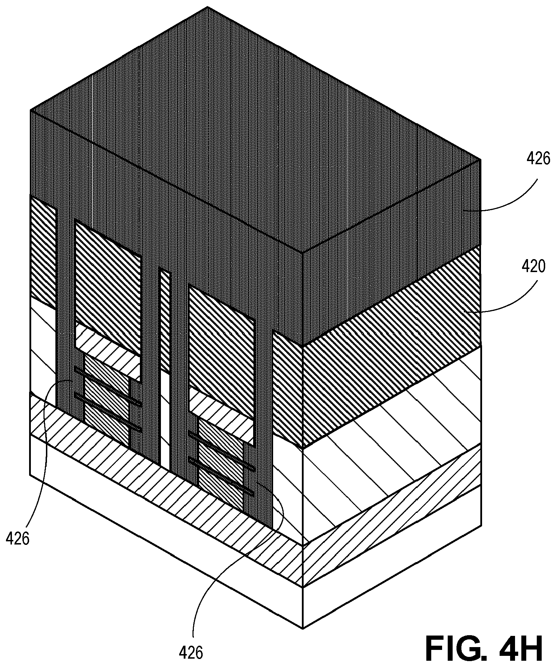

FIG. 4H shows a stage in the manufacturing process where a spacer material 426 is applied. In embodiments, spacer material 426 may be a low-k dielectric.

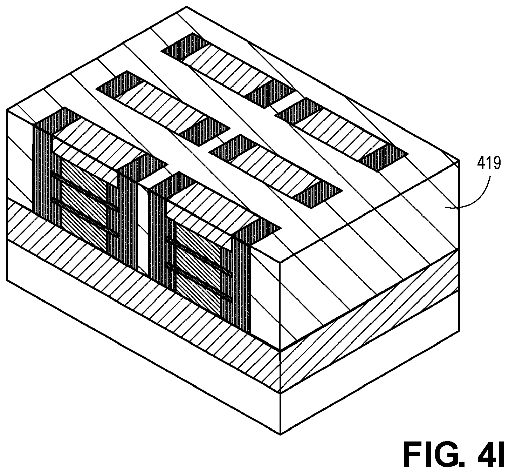

FIG. 4I shows a stage the manufacturing process where an etch is applied down to the dense covering 419.

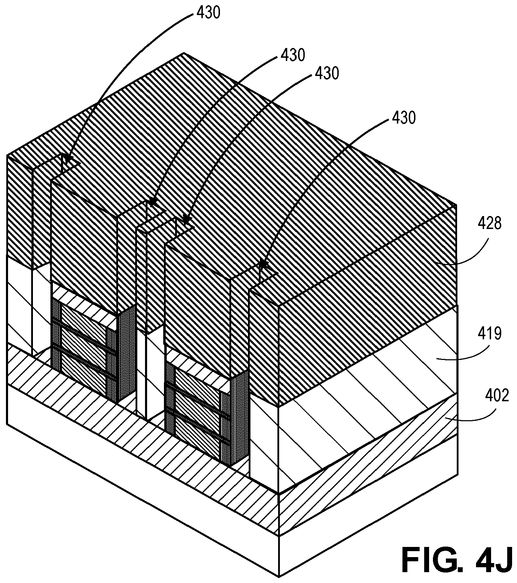

FIG. 4J shows a stage in the manufacturing process where another layer of photoresist 428 is applied, and openings 430 are made, and etching is applied to the etch stop layer 402. This may be done through a direct etch technique. This stage opens up the source and the drain of the transistor structure.

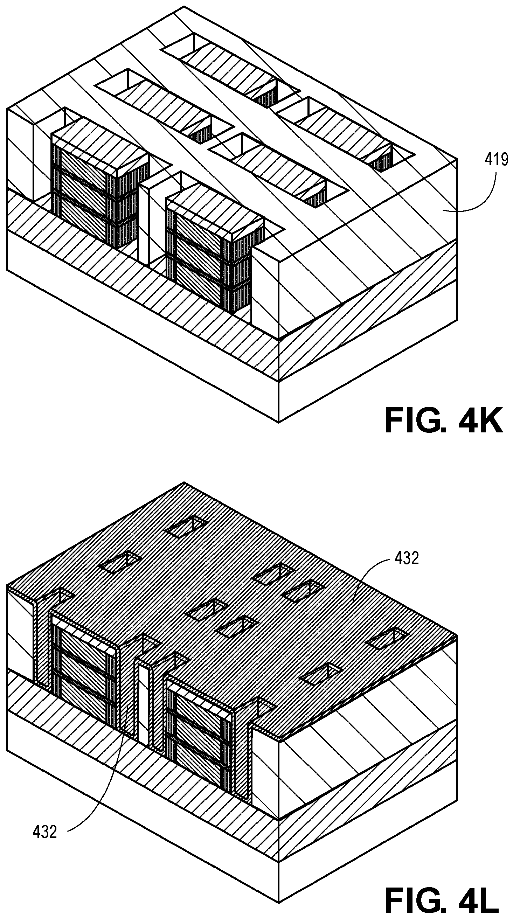

FIG. 4K shows a stage in the manufacturing process where the photoresist 428 is removed down to the dense covering 419.

FIG. 4L shows a stage in the manufacturing process where a contact metal 432 is applied. In embodiments, the contact metal 432 may be applied using atomic layer deposition process, and may include one or more of antimony (Sb), bismuth (Bi), ruthenium (Ru), cobalt (Co), copper (Cu), tungsten (W), gold (Au), silver (Ag), palladium (Pd) and/or associated alloys. Contact metal 432 may be similar to contact metal 330a, 332a, 330b, 332b of FIG. 3.

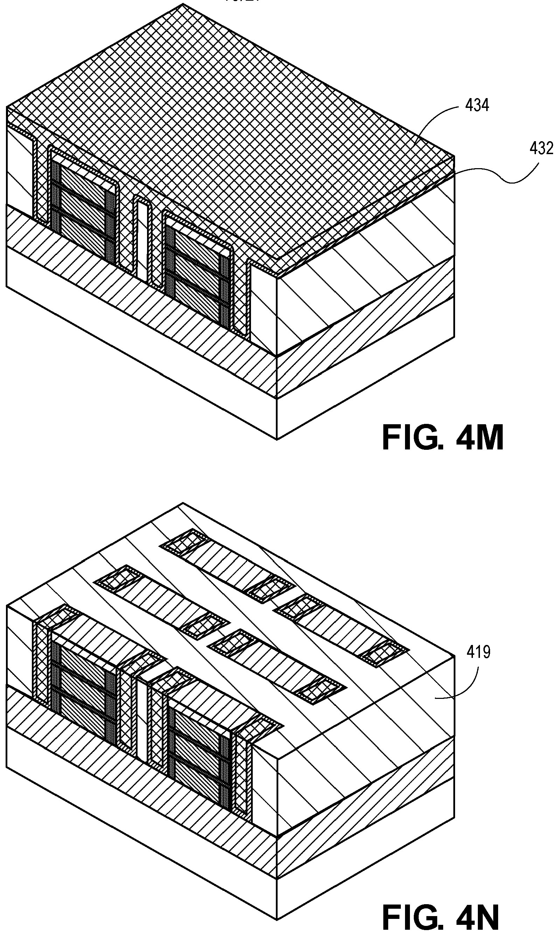

FIG. 4M shows a stage in the manufacturing process where a fill metal 434, which may be similar to fill metal 334 of FIG. 3. In embodiments, the fill metal 434 may be referred to as a backfill metal, and may include Co, W, Cu, Ru and/or associated alloys.

FIG. 4N shows a stage in the manufacturing process where the top contact metal 432 and the top fill metal 434 is etched away to the top of the dense covering 419.

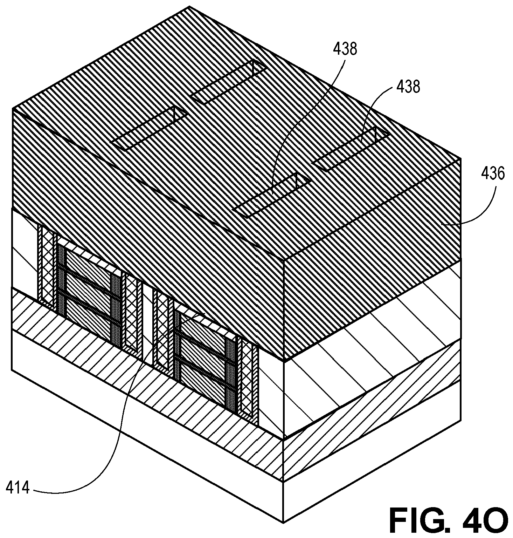

FIG. 4O shows a stage in the manufacturing process where another photoresist layer 436 is placed on top and openings 438 are made to expose the hard mask 414.

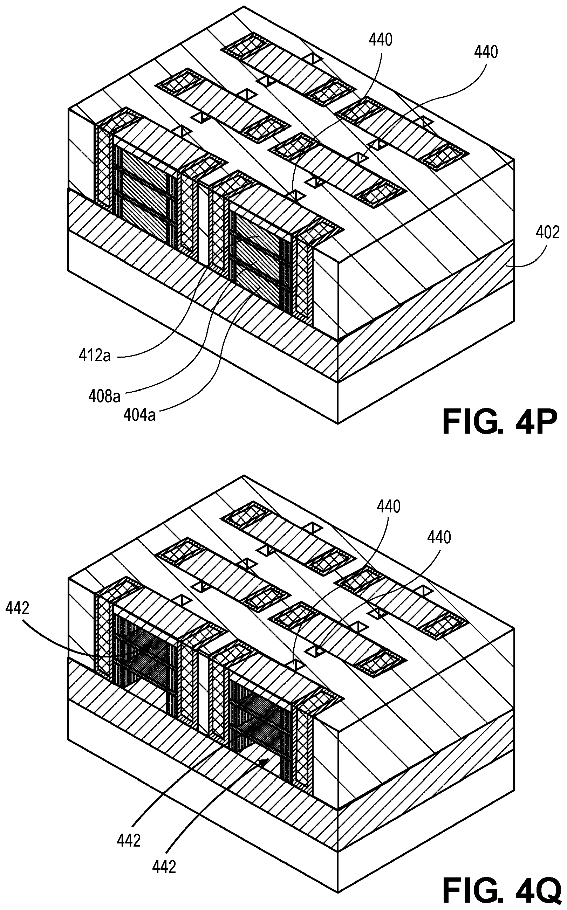

FIG. 4P shows a stage in the manufacturing process wherein etch is performed to open holes 440 that extend down to the etch stop 402 to expose the sacrificial layers 404a, 408a, 412a.

FIG. 4Q shows a stage in the manufacturing process where the sacrificial layers 404a, 408a, 412a have been etched through the holes 440 to create voids 442.

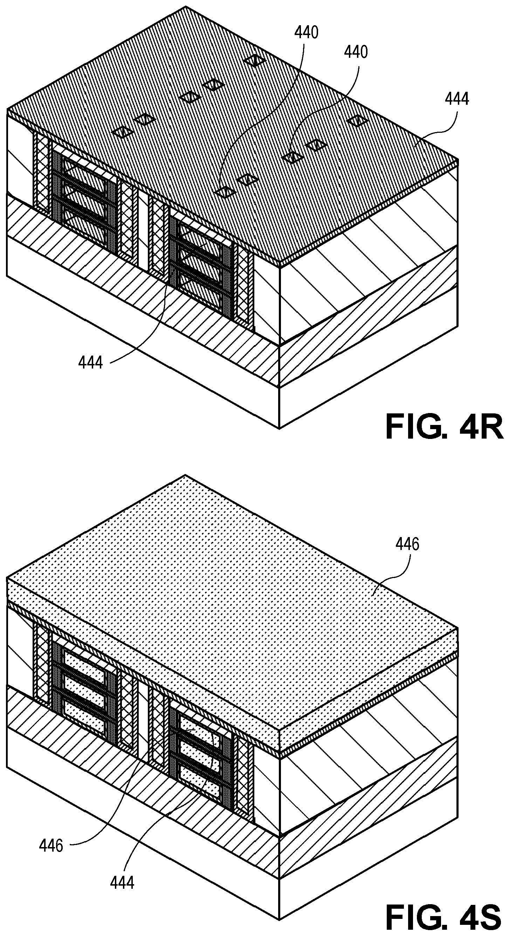

FIG. 4R shows a stage in the manufacturing process where a gate oxide 444 is applied through the holes 440 and coats the interior of the voids 442 from FIG. 4Q. Note that in this stage, depending on whether a Nmos or Pmos gate is desired the gate oxide 444 may be doped with elements that may include lanthanum, tungsten, molybdenum, hafnium, or aluminum.

FIG. 4S shows a stage in the manufacturing process where a gate metal 446 is applied through the holes 440 and fills in between the gate oxide 444.

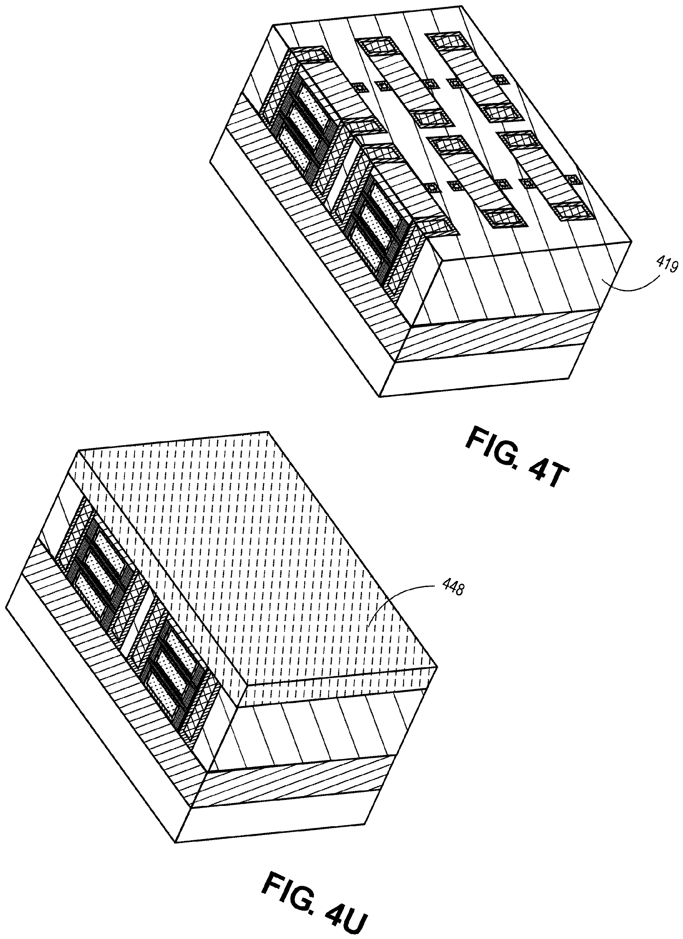

FIG. 4T shows a stage in the manufacturing process where a polish, such as a chemical mechanical polish (CMP), removes top layers down to dense covering 419.

FIG. 4U shows a stage in the manufacturing process where M0 local interconnect layers are formed. In embodiments, a low-k dielectric 448 is applied.

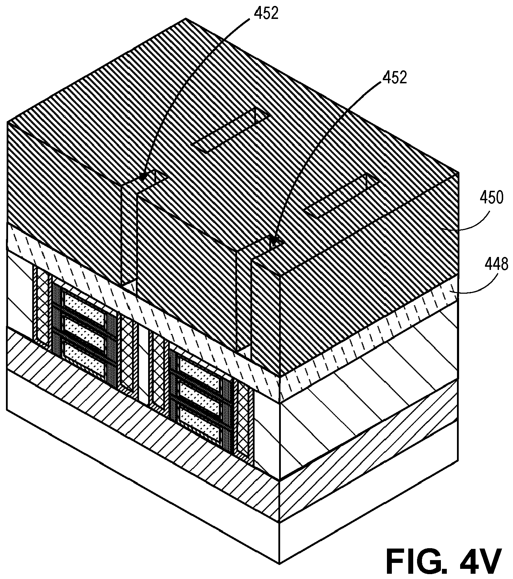

FIG. 4V shows a stage in the manufacturing process where a photoresist layer 450 is placed on top of the low-k dielectric 448, and openings 452 are formed in the photoresist layer 450.

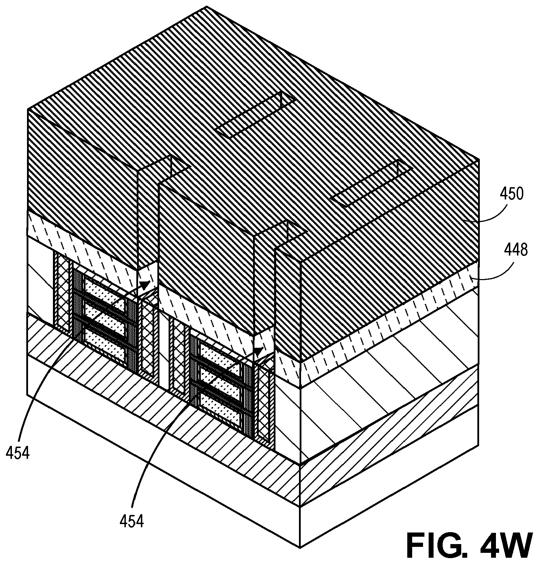

FIG. 4W shows a stage in the manufacturing process where an etch is performed to remove areas 454 within the low-k dielectric 448.

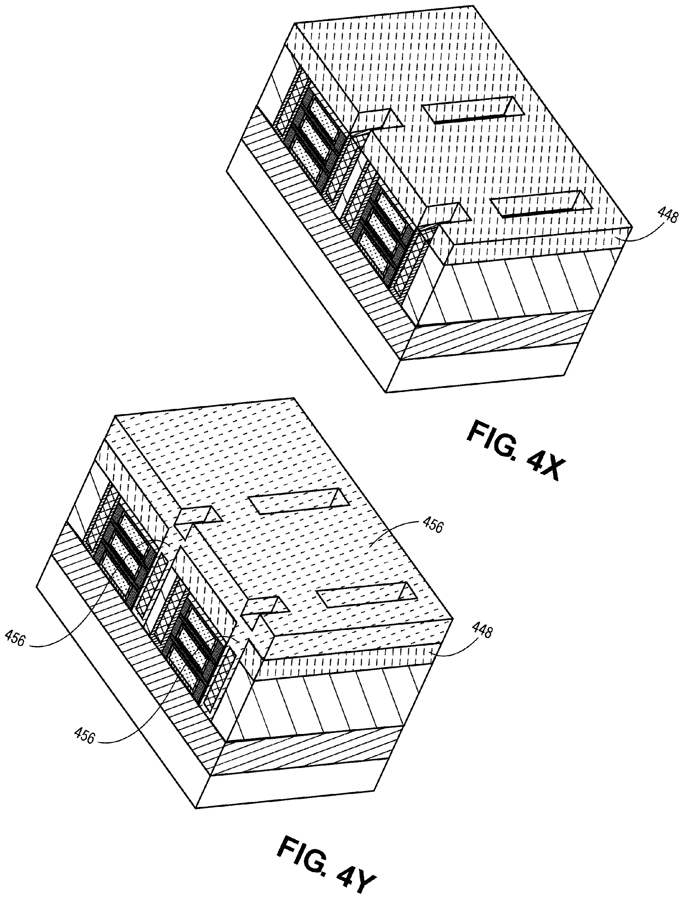

FIG. 4X shows a stage in the manufacturing process where the photoresist layer 450 has been removed to the surface of the low-k dielectric 448.

FIG. 4Y shows a stage the manufacturing process where a metal layer 456 has been applied over the surface of the low-k dielectric 448. In embodiments, the metal layer 456 may include cobalt or tungsten.

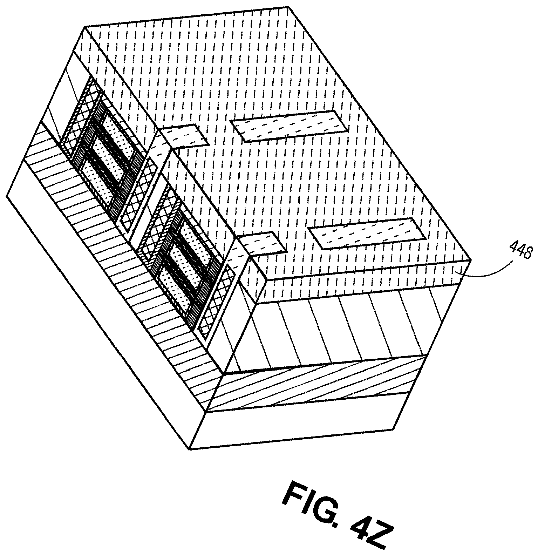

FIG. 4Z shows a stage in the manufacturing process where a CMP process has been applied to remove the metal layer 456 to the top of the surface of the low-k dielectric 448.

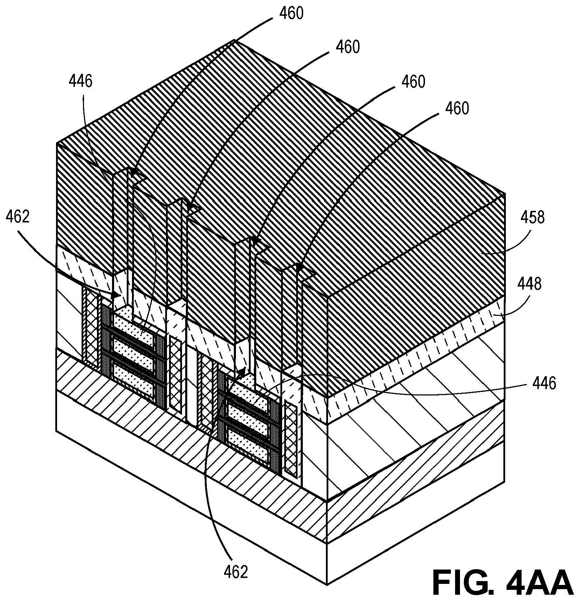

FIG. 4AA shows a stage in the manufacturing process where a photoresist layer 458 is placed on top of the low-k dielectric 448. Openings 460 are created within the photoresist layer 458, and an etch process is applied to etch cavities 462 down to the gate metal 446.

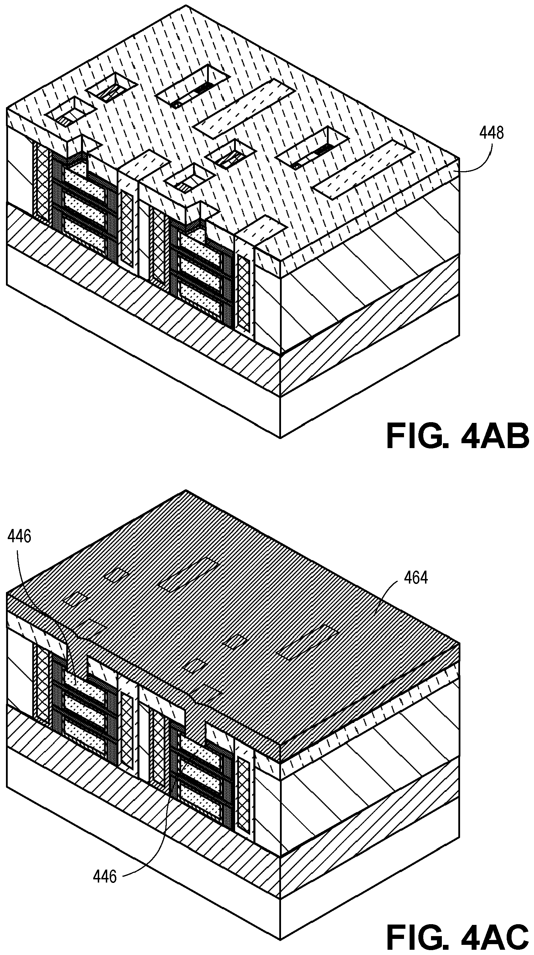

FIG. 4AB shows a stage in the manufacturing process where the photoresist layer 458 is stripped away to the top of low-k dielectric 448.

FIG. 4AC shows a stage in the manufacturing process where a metal layer 464 is applied to connect with the gate metal 446. In embodiments, the metal layer 464 may include cobalt, ruthenium, copper, tungsten, molybdenum, titanium, and/or nitrogen.

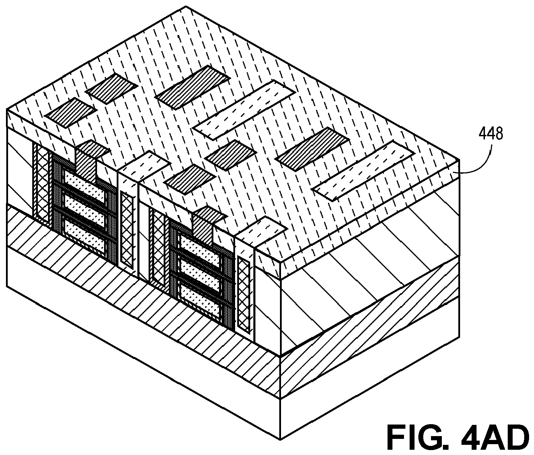

FIG. 4AD shows a stage in the manufacturing process where the metal layer 464 is polished down to the top of low-k dielectric 448. In embodiments, a dielectric may be used that contains silicon, oxygen, carbon, hydrogen, and/or nitrogen. For example, SiO₂ may be used.

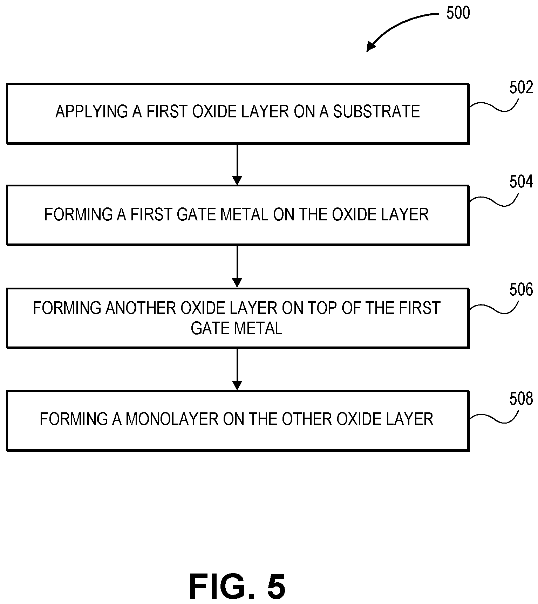

FIG. 5 illustrates an example process for manufacturing a transistor structure with a monolayer edge contact, in accordance with various embodiments. Process 500 may be implemented using the techniques and/or embodiments described herein, and in particular with respect to FIGs. 1-4AD.

At block 502, the process includes applying a first oxide layer on a substrate.

At block 504, the process further includes forming a first gate metal on the oxide layer.

At block 506, the process further includes forming another oxide layer on top of the first gate metal.

At block 508, the process further includes forming a monolayer on the other oxide layer.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or gate-all-around transistors such as nanoribbon and nanowire transistors. Although the implementations described herein may illustrate only Finfet transistors, it should be noted that the invention may also be carried out using planar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO2) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

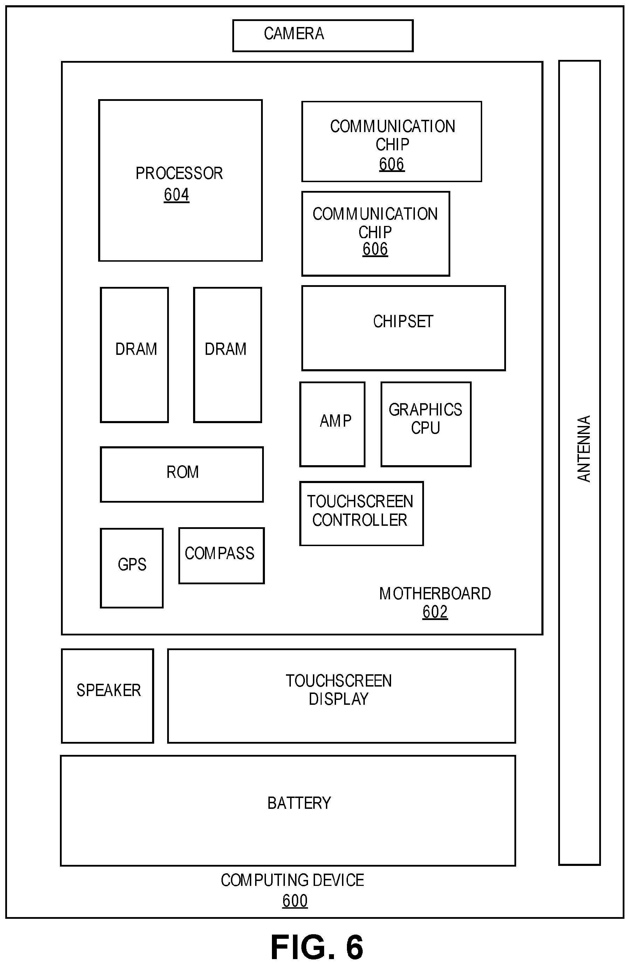

FIG. 6 illustrates a computing device 600 in accordance with one implementation of the invention. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another implementation of the invention, the integrated circuit die of the communication chip includes one or more devices, such as MOS-FET transistors built in accordance with implementations of the invention.

In further implementations, another component housed within the computing device 600 may contain an integrated circuit die that includes one or more devices, such as MOS-FET transistors built in accordance with implementations of the invention.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

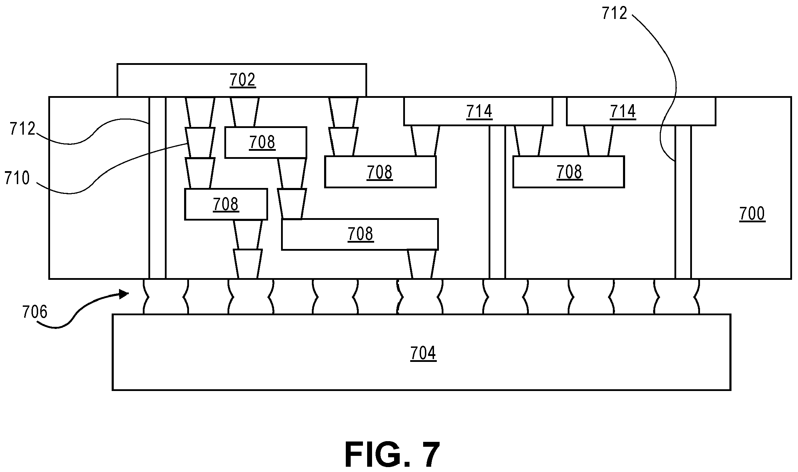

FIG. 7 illustrates an interposer 700 that includes one or more embodiments of the invention. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700.

The interposer 700 may be formed of an epoxy resin, a fiberglass-reinforced epoxy resin, a ceramic material, or a polymer material such as polyimide. In further implementations, the interposer 700 may be formed of alternate rigid or flexible materials that may include the same materials described above for use in a semiconductor substrate, such as silicon, germanium, and other group III-V and group IV materials.

The interposer 700 may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 700. In accordance with embodiments of the invention, apparatuses or processes disclosed herein may be used in the fabrication of interposer 700.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is a transistor structure comprising: a gate metal; a gate oxide on a side of the gate metal; and a monolayer on the gate oxide, the monolayer having a first side and a second side opposite the first side, wherein a first portion of an edge of the monolayer between the first side and the second side of the monolayer is coupled with a surface of a first contact metal, and wherein a second portion of the edge of the monolayer between the first side and the second side of the monolayer is coupled with a surface of a second contact metal.
Example 2 includes the transistor structure of example 1, wherein the monolayer includes a selected one or more of: sulfur (S), selenium (Se), tellurium (Te), tungsten (W), and molybdenum (Mo).
Example 3 includes the transistor structure of example 1, wherein the monolayer has a thickness of 3.3 angstroms (Å).
Example 4 includes the transistor structure of example 1, wherein the surface of the first contact metal or the second contact metal is substantially perpendicular to the first side or the second side of the monolayer.
Example 5 includes the transistor structure of example 1, wherein a distance along the first side of the monolayer between the surface of the first contact metal and the surface of the second contact metal is less than or equal to 15 nm.
Example 6 includes the transistor structure of example 1, wherein the monolayer further includes multiple monolayers that form a monolayer stack.
Example 7 includes the transistor structure of example 6, wherein the multiple monolayers are directly physically coupled with each other.
Example 8 includes the transistor structure of any one of examples 1-7, wherein the gate metal is a first gate metal and the monolayer is a first monolayer; and further comprising: a plurality of other gate metals in a stack below the first gate metal, wherein a gate oxide layer is above and below each of the other gate metals; a plurality of other monolayers, each other monolayer, respectively, above each of the plurality of the other gate metals and within the gate oxide layer; and wherein a first portion of an edge of each of the other monolayers between the first side and the second side of the monolayer is coupled with the surface of the first contact metal, and wherein a second portion of the edge of each of the monolayers is coupled with a surface of the second contact metal.
Example 9 includes the transistor structure of example 8, wherein a distance between a first monolayer and one of the other monolayers ranges from 6 nm to 10 nm.
Example 10 includes the transistor structure of example 8, wherein each of the plurality of monolayers further includes multiple monolayers.
Example 11 includes the transistor structure of example 8, wherein a number of the plurality of other gate metals is six or more.
Example 12 is a method comprising: applying a fist oxide layer on a substrate; forming a first gate metal on the oxide layer; forming another oxide layer on top of the first gate metal; and forming a monolayer on the other oxide layer.
Example 13 includes the method of example 12, wherein the monolayer has a first side and a second side opposite the first side; and wherein forming a monolayer on the oxide layer further includes: physically coupling a first portion of an edge of the monolayer between the first side and the second side with a surface of a first contact metal; and physically coupling a second portion of the edge of the monolayer with a surface of a second contact metal.
Example 14 includes the method of example 12, wherein a distance along the first side of the monolayer between the surface of the first contact metal and the surface of the second contact metal is less than or equal to 15 nm.
Example 15 includes the method of example 12, wherein forming a monolayer on the oxide layer further includes forming a plurality of monolayers on the oxide layer, wherein the monolayers are stacked on each other.
Example 16 includes the method of any one of examples 12-15, wherein the monolayer includes a selected one or more of: sulfur (S), selenium (Se), tellurium, tungsten (W), and molybdenum (Mo).
Example 17 includes the method of any one of examples 12-15, wherein the monolayer has a thickness of 3.3 angstroms (Å).
Example 18 is a system comprising: a substrate; and a transistor structure on the substrate, the transistor structure comprising: a gate metal; a gate oxide on a side of the gate metal, the gate oxide including hafnium (Hf); and a monolayer on the gate oxide, the monolayer having a first side and a second side opposite the first side, wherein a first portion of an edge of the monolayer between the first side and the second side of the monolayer is coupled with a surface of a first contact metal, and wherein a second portion of the edge of the monolayer between the first side and the second side of the monolayer is coupled with a surface of a second contact metal.
Example 19 includes the system of example 18, wherein the transistor structure is a first transistor structure, the gate metal as a first gate metal, the gate oxide is a first gate oxide, and the monolayer is a first monolayer; and further comprising: a second transistor structure on the substrate, the second transistor structure comprising: a second gate metal; a second gate oxide on a side of the second gate metal, the second gate oxide including aluminum (Al); and a second monolayer on the second gate oxide, the second monolayer having a first side and a second side opposite the first side, wherein a first portion of an edge of the second monolayer between the first side and the second side of the second monolayer is coupled with a surface of a third contact metal, and wherein a second portion of the edge of the second monolayer between the first side and the second side of the second monolayer is coupled with a surface of a fourth contact metal.
Example 20 includes the system of any one of examples 18-19, wherein the monolayer includes a plurality of monolayers stacked on each other.

## Claims

1. A transistor structure comprising:
a gate metal;
a gate oxide on a side of the gate metal; and
a monolayer on the gate oxide, the monolayer having a first side and a second side opposite the first side, wherein a first portion of an edge of the monolayer between the first side and the second side of the monolayer is coupled with a surface of a first contact metal, and wherein a second portion of the edge of the monolayer between the first side and the second side of the monolayer is coupled with a surface of a second contact metal.

2. The transistor structure of claim 1, wherein the monolayer includes a selected one or more of: sulfur (S), selenium (Se), tellurium (Te), tungsten (W), and molybdenum (Mo).

3. The transistor structure of either of claims 1 and 2, wherein the monolayer has a thickness of 3.3 angstroms (Å).

4. The transistor structure of any of claims 1-3, wherein the surface of the first contact metal or the second contact metal is substantially perpendicular to the first side or the second side of the monolayer.

5. The transistor structure of any of claims 1-4, wherein a distance along the first side of the monolayer between the surface of the first contact metal and the surface of the second contact metal is less than or equal to 15 nm.

6. The transistor structure of any of claims 1-5, wherein the monolayer further includes multiple monolayers that form a monolayer stack.

7. The transistor structure of claim 6, wherein the multiple monolayers are directly physically coupled with each other.

8. The transistor structure of claim 1, 2, 3, 4, 5, 6 or 7, wherein the gate metal is a first gate metal and the monolayer is a first monolayer; and further comprising:
a plurality of other gate metals in a stack below the first gate metal, wherein a gate oxide layer is above and below each of the other gate metals;
a plurality of other monolayers, each other monolayer, respectively, above each of the plurality of the other gate metals and within the gate oxide layer; and
wherein a first portion of an edge of each of the other monolayers between the first side and the second side of the monolayer is coupled with the surface of the first contact metal, and wherein a second portion of the edge of each of the monolayers is coupled with a surface of the second contact metal.

9. The transistor structure of claim 8, wherein a distance between a first monolayer and one of the other monolayers ranges from 6 nm to 10 nm.

10. The transistor structure of either of claims 8 and 9, wherein each of the plurality of monolayers further includes multiple monolayers.

11. The transistor structure of any of claims 8-10, wherein a number of the plurality of other gate metals is six or more.

12. A method comprising:
applying a fist oxide layer on a substrate;
forming a first gate metal on the oxide layer;
forming another oxide layer on top of the first gate metal; and
forming a monolayer on the other oxide layer.

13. The method of claim 12, wherein the monolayer has a first side and a second side opposite the first side; and wherein forming a monolayer on the oxide layer further includes:
physically coupling a first portion of an edge of the monolayer between the first side and the second side with a surface of a first contact metal; and
physically coupling a second portion of the edge of the monolayer with a surface of a second contact metal.

14. The method of either of claims 12-13, wherein a distance along the first side of the monolayer between the surface of the first contact metal and the surface of the second contact metal is less than or equal to 15 nm.

15. The method of any of claim2 12-14, wherein forming a monolayer on the oxide layer further includes forming a plurality of monolayers on the oxide layer, wherein the monolayers are stacked on each other.
